(19) Europäisches Patentamt
European Patent Office
Office européen des brevets

(11) Publication number: **0 016 305**
**B1**

(12) # EUROPEAN PATENT SPECIFICATION

(45) Date of publication of patent specification: **12.09.84**

(51) Int. Cl.$^3$: **H 01 L 29/28,** H 01 L 31/02, H 01 B 1/12, C 08 L 65/02

(21) Application number: **80100175.1**

(22) Date of filing: **15.01.80**

(54) **Electrically conducting compositions derived from poly(phenylene), and shaped article comprising such a composition.**

(30) Priority: **20.03.79 US 22237**

(43) Date of publication of application:
**01.10.80 Bulletin 80/20**

(45) Publication of the grant of the patent:
**12.09.84 Bulletin 84/37**

(84) Designated Contracting States:
**CH DE FR GB IT NL SE**

(56) References cited:
**FR-A-2 306 531**
**FR-A-2 373 166**
**GB-A-1 000 679**
**US-A-3 775 177**

**J.E. KATON: "Organic Semiconduting Polymers", Marcel Dekker Inc., 1968 New York, U.S.A.**

**BERICHTE DER BUNSENGESELLSCHAFT, vol. 68, no. 6, 1964, Weinheim, DE. F. BECK: "Elektrische Messungen zur Charakterisierung von polymeren organischen Halbleitern"**

(73) Proprietor: **ALLIED CORPORATION**
**Columbia Road and Park Avenue P.O. Box 2245R (Law Dept.)**
**Morristown New Jersey 07960 (US)**

(72) Inventor: **Ivory, Dawn Marie**
**2 Arrowhead Trail**
**Lake Hopatcong, New Jersey 07849 (US)**
Inventor: **Miller, Granville Guy**
**140 Western Avenue**
**Morristown, New Jersey 07960 (US)**
Inventor: **Chance, Ronald Richard**
**21 Davis Avenue**
**Morris Plains, New Jersey 07950 (US)**
Inventor: **Baughman, Ray Henry**
**41 Glacier Drive**
**Morris Plains, New Jersey 07960 (US)**

(74) Representative: **Myerscough, Philip Boyd et al**
**J.A.Kemp & Co. 14, South Square Gray's Inn**
**London, WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**EP 0 016 305 B1**

**Description**

BACKGROUND OF THE INVENTION

1. *Field of the Invention*

This invention relates to electrically conducting compositions, useful as electronic and optical materials, comprising the solid polymer poly(phenylene) and electron donor or acceptor materials, or mixtures thereof.

2. *Brief Description of the Prior Art*

The electronics industry is continuously searching for new and improved materials for fabricating electronic components. Likewise, the plastics industry is in need of materials which have the property advantages of conventional organic polymers, but which are also electrically conducting. There is a special need in these industries for obtaining conducting materials exhibiting direct current conductivities of at least about $10^{-4}$ $ohm^{-1}$ $cm^{-1}$, and preferably greater than one $ohm^{-1}$ $cm^{-1}$, which also have the desired processibility, mechanical properties, low cost, and low density characteristics of carbon-backbone organic polymers.

Carbon backbone polymers, possessing conductive properties, can be prepared by pyrolyzing or graphitizing organic polymers. Such resulting conductivity is most likely due to the formation of electrically conducting graphitic structures. However, such pyrolyzed or graphitized polymers are difficult to prepare in a controlled fashion, most likely exhibit undesirable variation in electrical properties, and are not conveniently processible.

The only non-pyrolyzed non-graphitic carbon-backbone organic materials known in the art with conductivities as high as $10^{-4}$ $ohm^{-1}$ $cm^{-1}$ are complexes of unsubstituted polyacetylene, $(—HC=CH—)x$, with specific electron donor or acceptor agents.

This is currently the state of the art despite the fact that researchers have tried for over twenty years to obtain highly conducting complexes of carbon-backbone polymers. Recent efforts in the field to discover substituted polyacetylenes which also form highly conducting complexes, comparable to those of unsubstituted polyacetylene, have not been successful.

Complexes of uncrosslinked polyacetylene with iodine, iodine chloride, iodine bromide, sodium, and arsenic pentafluoride having conductivities ranging from that of the undoped polymers to between 50 to 560 $ohm^{-1}$ $cm^{-1}$ at 25°C have been described in *J. Am. Chem. Soc. 100*, 1013 (1978). Also described therein are complexes of polyacetylene with hydrogen bromide, chlorine, and bromine having conductivities of up to at least between $7 \times 10^{-4}$ and 0.5 $ohm^{-1}$ $cm^{-1}$, where the highest conductivity in this range is for the bromine complex. L. R. Anderson, G. P. Pez, and S. L. Hsu in *J. Chem. Soc., Chemical Communications* pp. 1066—1067 (1978) describe bis(fluorosulfuryl) peroxide, $FSO_2OOSO_2F$, as a dopant for polyacetylene to produce a composition having a room temperature conductivity of about 700 $ohm^{-1}$ $cm^{-1}$. Also, the reference of *J. Chem. Soc. Chem. Comm.* pp. 489—490 (1978) reports that polyacetylene doped with $AgClO_4$ and $AgBF_4$ provides derivative materials having typical conductivities of up to 3 $ohm^{-1}$ $cm^{-1}$. The possible application of polyacetylene complexes as electronic devices is described in *App. Phys. Lett. 33*, pp. 18—20 (1978).

Although such polyacetylene complexes are useful as electronic materials, they posses the disadvantages of environmental and thermal instability of the matrix polyacetylene. For example, even in the absence of oxygen, cis-polyacetylene transforms to trans-polyacetylene at a rate of few percent a day at room temperature, which could result in a variation of electrical properties. Additionally, both isomers of polyacetylene readily react with oxygen, thereby changing the electronic properties of either doped or undoped polymer. The infusibility and insolubility of high molecular weight polyacetylene further precludes melt or solution processing and the thermal reactivity in the form of crosslinking reactions additionally precludes molding this polymer into shaped articles.

In contrast to polyacetylene, poly(phenylene) is a conjugated polymer having unusually high thermal and oxidative stability. The highest stability has been obtained for poly(phenylene) which largely consists of para-phenylene linkages:

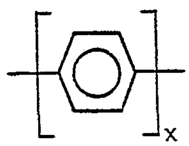

and which is commonly referred to as poly(p-phenylene). This polymer is stable at temperatures as high as 400°C in air and 550°C in inert atmospheres. Furthermore, poly (p-phenylene) exhibits exceptional resistance to radiation damage, as described in *J. Polym. Sci. 3*, pp. 4297—4298 (1965). Another advantage of poly(p-phenylene) is that objects having tensile strengths as high as 34,474 kPa (5000 psi) can be molded from this polymer using powder-metallurgical forming techniques without chemical degradation of the polymer, as described in *J. Polym. Sci. 22* pp. 1955—1969 (1978).

Previous efforts to obtain poly(phenylene) complexes having conductivities sufficiently high for applications as semiconductors or conductors have been unsuccessful. The highest reported room temperature conductivity (except as indicated below) is $4 \times 10^{-5}$ $ohm^{-1}$ $cm^{-1}$, which was obtained for a poly(p-phenylene) complex with iodine, as described in *Polymer Preprints 4,* pp. 208—212 (1963). The temperature dependence of conductivity, $\sigma$, is given by the expression $\sigma = \sigma_0$e-E/kT where $\sigma_0$ is a material constant, k is Boltzmann's constant ($8.6 \times 10^{-5}$ eV/degree, T is temperature in °K, and I is the activation energy for conductivity. E is reported by these authors to have a value of 0.87 eV between room temperature and —100°C. By contrast, a much smaller temperature dependence is normally expected for a material to be a useful semiconductor. The above reference also describes the formation of a complex between poly(p-phenylene) and tetracyanoethylene. However, in this case the observed conductivity at room temperature ($10^{-11}$ $ohm^{-1}$ $cm^{-1}$) is even lower than that observed for the iodine complex.

Complexes of poly(p-phenylene) with $I_2$, tetracyanoethylene, chloranil and $SbCl_5$ are referred to on pages 175 and 176 of J. E. Katon ed., Organic Semiconducting Polymers (1968). The lowest resistance reported was $6.5 \times 10^3$ ohm-cm for the $SbCl_5$ complex, referencing a presentation by K. Suzuki, Y. Yamamoto and H. Mikawa at the 17th Meeting of the Chemical Society of Japan, Tokyo, 1964. No explanation is given for this relatively low conductivity ($1.5 \times 10^{-4}$ S/cm or $ohm^{-1}$ $cm^{-1}$).

SUMMARY OF THE INVENTION

We have unexpectedly discovered that electron donors and electron acceptors can be incorporated into poly(p-phenylene) to produce novel materials having electrical conductivities which are continuously adjustable from $10^{-4}$ $ohm^{-1}$ $cm^{-1}$ to over 100 $ohm^{-1}$ $cm^{-1}$.

In accordance with this invention there is provided a composition comprising a solid poly(phenylene), consisting essentially of monomer units having para-, meta- or ortho-phenylene linkages, or mixtures thereof, having incorporated therein at least one doping agent characterized in that the doping agent is an electron donor or acceptor doping agent, or mixture thereof and in that

(a) the direct current conductivity of a composition incorporating an electron donor agent alone is greater than that of the undoped poly(phenylene); and

(b) the direct current conductivity of a composition incorporating an electron acceptor agent alone or mixed with an electron donor agent, is greater than one $ohm^{-1}$ $cm^{-1}$; said conductivity being measured by four-probe method at room temperature. Preferred embodiments are where the poly(phenylene) consists essentially of para-phenylene linkages, the conductor doping agent is arsenic pentafluoride, sodium or potassium naphthalene, said agent being present in an amount of $10^{-5}$ to 0.5 mole per mole of monomer units in said polymer.

Further provided is a shaped article of manufacture comprising the above-described composition. Preferred embodiments of the shaped article are an electrical conductor, a semiconductor, an n-p type junction and an infrared radiation absorber.

DESCRIPTION OF THE INVENTION AND THE PREFERRED EMBODIMENTS

The novelty of this invention is in the discovery that the electrical conductivity of poly(phenylene) can be surprisingly increased by the addition of specific electron donor agents, or increased to values of one $ohm^{-1}$ $cm^{-1}$ and greater by incorporating into the polymer specific electron acceptor agents, or admixture of donor and acceptor agents.

The reason why this result surprisingly occurs is not clearly understood. A theory that we do not wish to be bound by is that a "charge-transfer complex" is formed between the matrix host polymer and the incorporated electron donor or acceptor agent. This complex is strikingly different in electrical properties as contrasted to a simple mixture of the polymer and agent. The complex behaves electrically as a semiconductor or a metal while a simple mixture with an insulating dopant mainly exhibits the electrical properties of the matrix polymer, i.e. a non-conductor or an insulator. Thus, the term "incorporated therein" does not include simple mixtures of poly(phenylene) and electron donors or acceptors, or mixtures thereof, where the conductivity is no higher than poly(phenylene) or the dopant individually. The appearance of optically adsorption bands in the infrared, visible or ultraviolet regions in the doped polymer, which are not present in the dopant or polyphenylene taken separately, distinguishes between a simple mixture and a charge-transfer complex.

A moderately large number of electron donor or acceptor agents will operate to surprisingly increase the direct current conductivity of poly(phenylene), as for example, arsenic pentafluoride, Group IA metals and Group IA metal arenes. However, not all known doping agents are effective. Bromine and iodine, for example as disclosed below, are known agents for surprisingly increasing the conductivity of polyacetylene to greater than 100 $ohm^{-1}$ $cm^{-1}$, but are not effective in increasing the conductivity of poly(phenylene) to greater than $4 \times 10^{-5}$ $ohm^{-1}$ $cm^{-1}$. The reason for this is not clear. A theory that we do not wish to be bound by is that the incorporation of the doping agent into poly(phenylene) results in the fractional ionization, e.g. sodium atom to sodium cation, of at least about ten mole percent of the incorporated agent. This would be expected to lead then to formation of the charge-transfer complex of particular structure resulting in a dramatic increase in conductivity. One skilled in the art from this disclosure will be able to very simply test particular electron donor or acceptor agents, or mixtures

thereof, not specifically described herein, in poly(phenylene) to determine if a dramatic increase in conductivity occurs. Those resulting compositions incorporating an electron donor agent and having a direct current conductivity greater than that of the undoped polymer and those compositions incorporating an acceptor agent, or mixture of donor and acceptor agents, having a direct current conductivity of greater than one $ohm^{-1}$ $cm^{-1}$, are regarded as also being within the scope of the disclosed invention.

By the term "four-probe method", as used herein, is meant the known and accepted art method of measuring the electrical conductivity of a polymeric film or material using either A.C. or D.C. current between four contacts. A description of the four-probe method is made in *J. Am. Chem. Soc. 100*, pp. 1014—16 (1978), and hereby incorporated by reference for that purpose. Specific details regarding the apparatus and procedure used are given in the Examples.

The term "poly(phenylene)" as used herein refers to a generic class of solid polymers containing the following repeating monomeric phenylene units:

para, 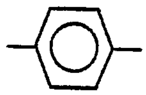 ; meta, 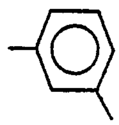 ; ortho, 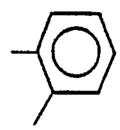 ,

either individually or mixtures thereof. The above monomeric units are also referred to herein, for example in individual instances, as "para linkages" or "paraphenylene" linkages.

A preferred polymer from the viewpoint of obtaining the highest conductivities for the composition is poly(p-phenylene) polymer consisting essentially of monomer units containing para-phenylene linkages. By this is meant that at least about 90 numerical percent of the monomer units are of the para-phenylene type as described above. Also, the polymer should be a solid and possess a sufficiently high molecular weight to be insoluble in conventional solvents for maximum conductivity and thermal stability. The molecular weight cannot be reliably determined for high molecular weight poly(p-phenylene) because of the insolubility and infusibility of this polymer. The color of the high molecular weight poly(phenylene) polymer typically ranges from brown to purple-black to black.

A wide variety of methods for synthesizing poly(phenylene) are well known. As an example, benzene polymerizes to poly(p-phenylene) under mild reaction conditions by various combinations of Lewis acid catalysts and oxidizing agents. A particularly efficient system is the aluminum chloride-cupric chloride system which provides poly(p-phenylene) in high yield after 0.5 hour at 35°C, as described in *J. Am. Chem. Soc. 85*, 454—458 (1963). As described in *J. Am. Chem. Soc. 81*, pp. 448—452 (1959) dehydrogenation of poly(1,3-cyclohexadiene) yields poly(p-phenylene). These and other methods known in the art are suitable for preparing high molecular weight poly(phenylene), characterized by insolubility in conventional solvents, infusibility and a brown-to-black color, which consists essentially of para-phenylene linkages. Such polymers are found in the present work to be most suitable for preparing poly(phenylene) complexes having the highest electrical conductivities.

Poly(phenylene) polymer having lower molecular weight, including those continuously down to p-quaterphenyl, also considered to be a poly(phenylene) in the subject compositions, or a substantially decreased concentration of para-phenylene linkages, have some advantages in solution and/or melt processibility. Such polymers can be obtained, for example, by the action of a sodium-potassium alloy on halogen derivatives of benzene, according to the method described in *J. Polym. Sci. 16*, 589—597 (1955). Other methods for synthesizing poly(phenylene) polymers which are both soluble and/or fusible are described in *J. Macromol Sci.* (Chem.), *Al*, 183197 (1967). The methods described therein utilize the cationic oxidation polymerization or copolymerization of aromatic hydrocarbons such as o-terphenyl, m-terphenyl, biphenyl, and benzene. All of the references described above relating to synthetic methods for preparing poly(phenylene) are hereby incorporated by reference for that purpose.

Doping agents applicable in the subject compositions include electron donor agents, which increase the inherent conductivity of poly(phenylene), and acceptor agents, or admixture of donor and acceptor agents which increase the conductivity of poly(phenylene) to a value greater than one $ohn^{-1}$ $cm^{-1}$. Preferably, the compositions have a direct current conductivity of about one $ohm^{-1}$ $cm^{-1}$, or greater, as measured by the four-probe method at room temperature.

Representative examples of applicable doping agents include electron donor agents such as Group IA metals, including lithium, sodium, potassium, rubidium, and cesium; and Group IA metal arenes, such as sodium and potassium naphthalene, sodium and potassium biphenyl; and electron acceptors such as Bronsted acids including $HClO_4$, non-metal oxides including those of $SO_3$ and $N_2O_5$; Group V element sulfides including $Sb_2S_5$, halides of Groups VIIB, VIII transition metals, IB, IIIA and VA, and halides of the inert gases, including $SbCl_5$, $BCl_3$, $CrO_2Cl_2$, $CrO_2F_2$, $SbF_3Cl_2$, $AsF_5$, $XeF_4$, $XeOF_4$, $SbF_5$, $PF_5$, $BF_5$, $BCl_5$, $SbBr_3$, $CuCl_2$, $NiCl_2$ and $MoCl_5$, and fluorine-containing peroxides including $FSO_2OOSO_2F$, or mixtures thereof. Preferred electron donor agents are selected from the group consisting of Group IA metals and Group IA metal arenes. Particularly preferred are sodium and potassium naphthalenes. Preferred electron acceptor agents are the Group V element halides and particularly preferred is arsenic pentafluoride.

The type of dopant chosen depends upon the electronic characteristics desired in the resulting composition. Donor dopants, such as the Group IA metals and Group IA metal arenes, provide an n-type conductive material (electron conductivity) while acceptor dopants, such as $AsF_5$, provide a p-type material (hole conductivity). Thus, also an embodiment of the subject composition is where the subject composition exhibits the electrical properties of a semiconductor. Preferred embodiments of the subject composition are where the semiconductor is of the n-type, or of the p-type.

The interface between electron donor-doped and acceptor-doped compositions provides an n-p junction which can serve, for example, as a rectifier. Such junctions can be provided by methods well known in the art, such as by mechanically pressing together sheets of n-doped and p-doped materials. Alternately, one end of a sheet of polymer can be doped with a donor while the opposite end is doped with an acceptor, thereby providing an n-p junctions at the interface between these differently doped regions.

The concentration of conductor doping agent in the composition is preferably from $10^{-5}$ to 0.5 mole per mole of monomer unit in the polymer. The highest conductivity is generally obtained by using either donor or acceptor dopants individually, rather than as a mixture. The conductivity generally increases with increasing dopant concentration and the highest obtainable dopant concentration normally corresponds to less than about 0.5 mole of dopant per mole of monomer units in poly(phenylene). The major conductivity increase in going from undoped poly(phenylene) to the fully doped polymer generally occurs at less than about one fifth of this value.

We have found that the halogens, iodine and bromine fail to provide highly conducting poly(phenylene) compositions, in contrast with the case for polyacetylene. However, we have found that highly conducting compositions are obtained using chlorine as a dopant for poly(phenylene).

Various methods for incorporating the conductor doping agent into poly(phenylene) can be employed to form charge-transfer complexes. These methods include, for example, addition of the doping agent from the gas phase, from solution phase, in the melt phase, or by intimately commingling solid materials. Similarly, electrochemical reactions can be used for the formation of charge-transfer complexes of poly(phenylene). If very high electrical conductivities are sought, it is important to avoid those doping conditions, such as too high a temperature, which disrupts the covalent bonds in the poly(phenylene) molecule, such as by halogenation, sulfonation, or nitration. Preferably, temperatures less than 100°C and less than or equal to room temperature are typically employed, especially for highly oxidizing dopants such as arsenic pentafluoride. In general, where the doping agent is a gas or a solid, having an appreciable vapor pressure at room temperature, such as arsenic pentafluoride, it is preferred to contact the solid poly(phenylene) with the doping agent in the gaseous or vapor state and preferably at reduced pressure. Where the doping agent is a solid at room temperature, it is preferred to contact the poly(phenylene) with a solution of said doping agent in an inert solvent therefor. Representative solvents include diethyl ether, tetrahydrofuran and the like. However, basic solvents, such as ammonia, are preferably excluded in acceptor doping if the highest conductivities are desired. The rate of addition of the dopant to the poly(phenylene) in the vapor phase is normally largely determined by the reaction temperature and the concentration (or vapor pressure) of the dopant. This rate is not crucial. However, if a complex having the optimized conductivity is required it is desirable to add the dopant at as slow a rate as is consistent with desired rates of manufacture. This normally requires reducing dopant concentration or gas pressure, reducing reaction temperature, and for the case of electrochemical reaction, reducing current flow from those values which provide maximum doping rate.

The dopant can be added to the poly(phenylene) either before, during, or after fabrication of the polymer into the form used for a particular application. For solution and/or melt processible poly(phenylenes), conventional polymer processing technology can be used to derive desired forms including films and fibers for the polymer, wherein the dopant can generally be added before dissolution or melting of the polymer, during the solution or melt processing, or after the product shape is provided by the solution or melt processing. For the poly(phenylenes) which are insoluble and infusible, pressure compaction or pressure sintering techniques can be used to fabricate this polymer into desired shapes, as described in *J. Appl. Polym. Sci. 22,* pp. 1955—1969 (1978). Again, the dopant can in general be added either before, during, or after the molding process. However, for dopants which lack high temperature stability, the post-molding doping process is preferred. This latter process can also provide materials which are conductive on the surface and insulating inside, if the time of dopant exposure is insufficient for dopant diffusion into the bulk of the article.

A characteristic feature of preferred compositions of the present invention is that these compositions, rather than being black, like compositions described in the prior art, are instead coloured; for example, a bronze-gold color for heavily doped potassium and sodium complexes and a green-metallic color for heavily doped $AsF_5$ complexes. These colors, which generally differ from those of the undoped polymers, reflect the changed electronic structure of the materials.

We have unexpectedly found that poly(phenylene) doped with a high concentration of $AsF_5$, of about 0.2 moles dopant per mole of monomer unit, has a much higher stability than the corresponding heavily-doped $AsF_5$ complex of graphite. The reference, *Materials Science and Engineering 31,* 161—167 (1977) describes that both Stage 1 and Stage 2 complexes of $AsF_5$ with graphite

decompose rapidly in air, accompanied by gross exfoliation and emission of fumes of white solids. Also, $AsF_5$-doped polyacetylene is highly sensitive to air exposure, which results in rapid formation of the cubic modification of $As_2O_3$. By contrast, no fume emission or exfoliation is observed with the poly(phenylene)-$AsF_5$ complex and only relatively slow changes occur in electrical conductivity.

Also a subject of this invention is a shaped article of manufacture comprising the subject composition. Our discovery that poly(phenylene) forms conductive charge transfer complexes with certain electron acceptors and certain electron donors permits the fabrication of electrical conductors, semiconductor devices, such as rectifying diodes and transistors, n-p junctions, using the subject compositions and the well-known technologies of device fabrication from n-type and p-type materials. The technology applied to the inorganic polymeric material, $(SN)_x$, described in *Appl. Phys. Lett. 33,* pp. 812—814, (1978) hereby incorporated by reference, for the construction of Schottky-barrier devices, useful as solar cells, can be used to construct devices from the subject compositions. The subject compositions can function as either the metallic or the semiconductor part of such a metal-semiconductor barrier device, depending upon the extent of doping of the polymer. A major advantage of poly(phenylene) as a junction material in such applications, as compared with the inorganic polymer $(SN)_x$, or the polyacetylene complexes described in *Appl. Phys. Lett 33,* pp. 18—20 (1978), lies in its unusually high thermal stability. Also, highly conducting poly(phenylene) complexes are also highly absorbing over a wide spectral region in the infrared region. Hence, these materials can be used as infrared absorbers in filtering materials as, for example, in protective eyeglass and solar energy applications. Also, since the subject compositions are conducting, they can be used as anti-static materials or devices, such as a shaped gasket inside the lid of a solvent can.

## Example 1

This example describes the doping of poly(phenylene) with an electron acceptor ($AsF_5$) to produce a highly conducting material.

Poly(phenylene) was prepared by the oxidative cationic polymerization of benzene as described in *J. Am. Chem. Soc. 29,* pp. 100—104 (1964) and hereby incorporated by reference for that purpose. Elemental and functional analyses for the reaction product are in agreement with those described in the above reference for a poly(phenylene) consisting essentially of para-phenylene linkages.

One and one-half grams of this polymer were pressed into a cylindrical pellet at $2.76 \times 10^5$ kPa (40,000 psi) in a 2.54 cm (1″) diameter stainless steel mold, removed from the mold and annealed at 400°C under ultra-high purity, commercially obtained nitrogen gas for 24 hours. Four electrodes were painted with an electrically conducting cement. Electrodag$^{DM}$, on the flat surfaces of this disk and placed in a colinear arrangement 1 mm apart. Platinum wires were used to contact these electrodes, so that electrical conductivity could be continuously monitored during doping process using the standard fou-point probe technique. The sample was then placed in a Pyrex-type glass cell with provisions for evacuation, the introduction of dopants, and with glass-metal seals to permit exit of wires connected to the four electrodes on the sample. The two outer electrodes were connected to a Keithley Model 163 current source. The center wires were connected to a Keithley Model 616 Electrometer for voltage measurement. This arrangement permitted continuous monitoring of the voltage and current, whereby electrical conductivity could be obtained by Ohm's Law calculations.

The cell containing the sample was evacuated to about $5.10^{-1}$ torr. At this point the conductivity measured for the undoped poly(phenylene) pellet was about $3.10^{-12}$ ohm$^{-1}$ cm$^{-1}$. The $AsF_5$ was added to the conductivity cell in 22 equal increments of dopant during a two day period, wherein each increment produced about a 3 torr increase in pressure for the cell volume. The electrical conductivity of the poly(phenylene) progressively increased over the two day period. During this time period the initial purple-black-metallic appearance of the compressed pellet changed to green-metallic. The final conductivity achieved after the 22th increment during the two day period was 130 ohm$^{-1}$ cm$^{-1}$. This conductivity is greater than that of the original polymer by a factor of about $10^{14}$. The conductivity decreased slightly to about 120 ohm$^{-1}$ cm$^{-1}$ upon standing in dynamic vacuum overnight. The temperature dependence of conductivity was measured down to 77°K, where the conductivity observed was 50 ohm$^{-1}$ cm$^{-1}$. The observed temperature dependence from room temperature down to 77°K can be described by an Arrhenius expression wherein the activation energy is calculated to be 0.01 eV.

## Example 2

This example describes the preparation of a highly conducting material by treatment of poly(phenylene) with an electron donor, potassium naphthalene, and the control of such conductivity through subsequent treatment with an electron acceptor material, arsenic pentafluoride.

Poly(p-phenylene) powder, prepared as in Example 1, incorporating four parallel platinum wires, was compressed into a 12 mm diameter disc-shaped pellet at $8.27 \times 10^5$ kPa (120,000 psi). The embedded wires were exposed by cutting away portions of the solid pellet until the exposed portions were long enough to permit attachment to the four-point probe conductivity apparatus described in Example 1. After heating at 400°C for 24 hours under ultra high purity nitrogen gas, the wired pellet was positioned in a Pyrex glass cell along with 0.8 g powdered potassium naphthalene. The cell was

evacuated and oxygen-free tetrahydrofuran (THF) admitted until the pellet was totally immersed in the potassium naphthalene solution.

Conductivity in the pellet increased over a period of 96 hours until a level of 7.2 $ohm^{-1}$ $cm^{-1}$ was attained. Washing the pellet, now a bronze-gold color, thoroughly with THF and drying under vacuum did not affect this conductivity value. The thoroughly washed pellet was then exposed to arsenic pentafluoride at a pressure of 45 torr. The conductivity value dropped to 0.57 $ohm^{-1}$ $cm^{-1}$ after 33 minutes, then increased once again to 44 $ohm^{-1}$ $cm^{-1}$ in two more hours.

The conductivity of the potassium treated poly(p-phenylene) decreased slightly when the pellet was cooled to liquid nitrogen temperature. The subsequent treatment with arsenic pentafluoride gave a material whose conductivity decreased from 44 $ohm^{-1}$ $cm^{-1}$ to 24 $ohm^{-1}$ $cm^{-1}$ when cooled to liquid nitrogen temperature.

Example 3

Poly(p-phenylene) powder, prepared as in Example 1, was compression molded at 8.27 × $10^5$ kPa (120 psi) pressure into five different cylindrical pellets, each 1.25 cm in diameter and about 0.1 cm thick. These pellets were annealed at 400°C under dry nitrogen gas for 24 hours and weighed after returning to room temperature. Electrodes were attached to one of the pellets (sample #1) as described in Example 1. This pellet was suspended in the conductivity apparatus by four platinum wires attached to the electrodes as described in Example 1. The remaining four pellets were placed on a platinum screen support in the conductivity apparatus, which was evacuated to $10^{-6}$ torr. The conductivity of sample #1 (undoped) was about $10^{-12}$ $ohm^{-1}$ $cm^{-1}$. Conductivities of the other samples were not measured prior to doping. Arsenic pentafluoride, in the vapor form, was introduced into the conductivity apparatus at a pressure of 455 torr and the conductivity was measured as a function of time after exposure to $AsF_5$ and the results listed below in Table I.

TABLE I

| $AsF_5$ Exposure Time (hours) | Conductivity, ($ohm^{-1}$ $cm^{-1}$) |
|---|---|
| 0 | $10^{-12}$ |
| 0.1 | 0.27 |
| 0.2 | 0.41 |
| 0.5 | 0.70 |
| 1.0 | 1.4 |
| 2.0 | 5.5 |
| 3.0 | 72.3 |
| 4.0 | 140.3 |
| 5.0 | 154.9 |

After five hours of exposure to $AsF_5$, the cell was evacuated to $10^{-6}$ torr. The conductivity decreased slightly on evacuation to 145 $ohm^{-1}$ $cm^{-1}$ after 16 hours. The conductivity apparatus was transferred to a $N_2$ filled glove bag. Samples 2 through 5 were weighed and their conductivities measured in the glove bag. Results are shown below in Table II. The conductivities of the pellets were measured using a Jandel Engineering Ltd. four-point probe apparatus and the Keithley Voltmeter and current source.

TABLE II

| Sample # | Initial Wt. (g) | Final Wt. (g) | Wt. Fraction $AsF_5$ | Conductivity ($ohm^{-1}$ $cm^{-1}$) |
|---|---|---|---|---|
| 1 | 0.13707 | — not measured — | | 145 |
| 2 | 0.13581 | 0.20971 | 0.352 | 103 |
| 3 | 0.13775 | 0.24416 | 0.436 | 170 |
| 4 | 0.13968 | 0.20746 | 0.327 | 103 |
| 5 | 0.14030 | 0.22086 | 0.365 | 140 |

The average conductivity value was 132 $ohm^{-1}$ $cm^{-1}$. The average weight fraction of $AsF_5$ in the doped samples was 0.37; this corresponds to a 0.21 mole fraction of $AsF_5$ in $(C_6H_4)_x$ or about one $AsF_5$ molecule per four monomer units. The conductivity of sample #1 was measured as a function of time under exposure to laboratory air. No visible fumes or visible exfoliation of the sample were observed during air exposure. The conductivity results are listed below in Table III.

TABLE III

| Air exposure time (hrs) | Conductivity ($ohm^{-1}$ $cm^{-1}$) |
|---|---|
| 0 | 145 |
| 0.3 | 143 |
| 0.8 | 144 |
| 1.0 | 138 |
| 1.5 | 128 |
| 2.5 | 112 |
| 3.4 | 99 |
| 4.0 | 90 |
| 4.7 | 78 |
| 5.0 | 75 |

After a few hours exposure to air, droplets of an acidic liquid appeared on the surface of the pellet. After five hours, Sample #1 was dipped in water for about 1 minute; the conductivity was unaffected.

Example 4

The following example illustrates doping alternately with n-type and p-type dopants. A 1.0 cm diameter x 0.1 cm thick pellet of poly(p-phenylene) was prepared using the method described in Example 1. After annealing at 400°C under nitrogen gas for 24 hours, the pellet was exposed to $AsF_5$ vapor until the conductivity of the pellet increased to $1.1 \times 10^{-2}$ $ohm^{-1}$ $cm^{-1}$. At this point the apparent activation energy for conductivity was 0.02 eV. The doped pellet was then exposed to ammonia gas. Within ten minutes the conductivity decreased to $1 \times 10^{-8}$ $ohm^{-1}$ $cm^{-1}$. After evacuation of the cell to $10^{-5}$ torr, the conductivity further decreased to $10^{-11}$ $ohm^{-1}$ $cm^{-1}$.

Example 5 (Comparative Example)

The following example demonstrates that bromine does not form a highly conducting complex with poly(p-phenylene).

A 2.54 dm (1″) diameter by 0.1 cm thick poly(phenylene) pellet was prepared by pressing 2 gm of poly(phenylene) at $2.76 \times 10^5$ kPa (40,000 psi). This pellet was annealed for 24 hrs at 400°C under nitrogen gas. The electrode and sample configuration were the same as described in Example 1. After evacuation to $10^{-6}$ torr, the conductivity of the undoped sample was $6 \times 10^{-12}$ $ohm^{-1}$ $cm^{-1}$. $Br_2$ gas

was introduced into the chamber, whereupon the conductivity rapidly increased to $10^{-7}$ $ohm^{-1}$ $cm^{-1}$. After 20 hours exposure to $Br_2$, the conductivity reached a peak value of $1.0 \times 10^{-6}$ $ohm^{-1}$ $cm^{-1}$. After 40 hours exposure to high vacuum, the conductivity decayed to $1.4 \times 10^{-7}$ $ohm^{-1}$ $cm^{-1}$. A temperature dependence was recorded at this point yielding a calculated activated energy of 0.3 eV.

Example 6

This example describes the preparation of a highly conductive material by treatment of poly(p-phenylene) with an electron donor (sodium naphthalene).

Poly(p-phenylene) powder, as prepared in Example 1, was compressed into a disc-shaped pellet (12 mm in diameter, 1 mm thick) at 8.27 kPa (120,000 psi). After heating at 400°C for 24 hr under high purity nitrogen gas, the metallic purple-colored pellet was placed in one leg of an H-shaped Pyrex glass cell. This cell is designed to allow irrigation of the pellet by a THF solution of sodium naphthalene prepared by intereacting sodium metal (0.1 g) with naphthalene (0.6 g) in dry, $O_2$-free THF in the other leg. After 24 hr of contact with the pellet, the sodium naphthalene solution was filtered off and the pellet washed in dry THF until no discoloration of the wash liquid occurred. Drying the pellet overnight under a vacuum of $5 \times 10^{-6}$ torr gave a golden-brown material which showed signs of swelling and flaking. Measurement of conductivity with an ohmmeter in a strictly controlled dry argon atmosphere gave a lower limit of $2 \times 10^{-2}$ $ohm^{-1}$ $cm^{-1}$ for the conductivity.

Example 7

Two 4 mg KBr pellets were prepared by compression with an applied torque of 23.7 N.m (210 inch-pound) in a MiniPress™ pellet-maker for infrared spectroscopy. One mg of poly (p-phenylene), prepared as in Example 1, was compressed onto the surface of one of these pellets using the above molding conditions.

An IR spectrum was taken of the poly(phenylene)/KBr pellet as the sample and the KBr pellet as the reference.

Both of these pellets were contacted with $AsF_5$ vapor using the same method as described in Example 1. An IR spectrum was again taken with poly(phenylene): $AsF_5$/KBr as the sample and KBr pellet as the reference. The spectrum for undoped poly(phenylene) was identical to that reported in *J. Org. Chem., 29,* pp. 100—104 (1964), with prominent vibrational transitions at 800, 1000, 1400 and 1480 $cm^{-1}$. These vibrational transitions are completely masked in the doped sample which shows large increases in infrared absorption over the range from at least 4000 $cm^{-1}$ down to at least 200 $cm^{-1}$, which are the limits of the measurement. On exposure of the doped pellet to $NH_3$ vapor, the infrared absorption dramatically decreases and the vibrational transitions associated with the undoped polymer reappeared. This effect is due to compensation of the $AsF_5$ acceptor by the $NH_3$ donor as discussed in Example 4. This experiment demonstrates that the conductive complex strongly absorbs over a broad band in the infrared, which indicates that such materials can be used in applications requiring an infrared shield, such as in solar energy and optical applications.

Furthermore, the reversibility of the optical behaviour demonstrates that the novel properties of the subject compositions do not arise because of covalent bond formation, between a dopant species and the polymer chains, such as the replacement of the chain hydrogens with halogens. It is well known in the art that less easily reversible reactions such as sulfonation, nitration and halogenation will occur if a highly oxidizing chemical is added at too high a temperature.

Example 8

The doping of p-quaterphenyl, the four phenylene unit poly(p-phenylene), with the electron acceptor, $AsF_5$, gives a highly conducting material.

A 12.7 mm (1/2") disc-shaped pellet of commercially obtained p-quaterphenyl powder pressed at $8.27 \times 10^5$ kPa (120,000 psi) was attached to a four point conductitivity-measuring apparatus, as described in Example 1. The conductivity cell containing the wired pellet was evacuated to $5 \times 10^{-6}$ torr and then 7 torr of $AsF_5$ was introduced throughout the vacuum line, including the conductivity cell. Almost immediately the pellet changed color from ivory to a light green, with an accompanying rise in conductivity. The contents of the vacuum line were condensed into the cell using liquid nitrogen and then the cell was allowed to warm to room temperature. The pellet's color deepened through dark green to a metallic purple; the conductivity of the pellet at this point was $3.9 \times 10^{-3}$ $ohm^{-1}$ $cm^{-1}$. After 30 minutes another 7 torr pressure increment of $AsF_5$ was condensed into the conductivity cell. After warming to room temperature the pellet had blackened. The conductivity rose to $1.2 \times 10^{-1}$ $ohm^{-1}$ $cm^{-1}$. After exposure under these conditions for 18 hours the conductivity was 8.9 $ohm^{-1}$ $cm^{-1}$.

## Claims

1. A composition comprising a solid poly(phenylene), consisting essentially of monomer units having para-, meta- or ortho-phenylene linkages, or mixtures thereof, having incorporated therein at least one doping agent characterised in that the doping agent is an electron donor or acceptor doping agent, or mixture thereof and in that

(a) the direct current conductivity of a composition incorporating an electron donor agent alone is greater than that of the undoped poly(phenylene), and

(b) the direct current conductivity of a composition incorporating an electron acceptor agent alone or mixed with an electron donor agent, is greater than one $ohm^{-1}$ $cm^{-1}$; said conductivity being measured by the four-probe method at room temperature.

2. A composition according to claim 1 wherein said doping agent is at least one of lithium, sodium, potassium, rubidium, cesium, sodium naphthalene, potassium naphthalene, sodium biphenyl, potassium biphenyl, $HClO_4$, $SO_3$, $N_2O_5$, $Sb_2S_5$, $SbCl_5$, $BCl_3$, $CrO_2Cl_2$, $CrO_2F_2$, $SbF_3Cl_2$, $AsF_5$, $XeF_4$, $XeOF_4$, $SbF_5$, $PF_5$, $BF_5$, $BCl_5$, $SbBr_3$, $CuCl_2$, $NiCl_2$, $MoCl_5$ and $FSO_2OOSO_2F$.

3. A composition according to claim 1 wherein said agent is an electron donor selected from Group IA metals and Group IA metal arenes.

4. A composition according to claim 1 wherein said agent is an electron acceptor which is a Group V halide.

5. A composition according to any one of the preceding claims wherein said doping agent is present in an amount of form $10^{-5}$ to 0.5 mole per mole of monomer unit in said poly(phenylene).

6. A composition according to any one of the preceding claims wherein said poly(phenylene) consists essentially of monomer units containing para-phenylene linkages.

7. A shaped article of manufacture comprising a composition as claimed in any one of claims 1 to 6.

8. A shaped article according to claim 7 which is an electrical conductor, a semi-conductor, an n-p junction, an infrared radiation absorber or an antistatic device.

## Patentansprüche

1. Ein festes Poly-(phenylen) enthaltende Zusammensetzung, die im wesentlichen aus Monomereinheiten mit para-, meta- oder ortho-Phenylenbindungen oder Gemischen derselben besteht und darin eingelagert wenigstens einen Dotierstoff aufweist, dadurch gekennzeichnet, daß der Dotierstoff ein Elektronendonor- oder Ekeltronenakzeptor-Dotierstoff oder ein Gemisch hiervon ist und daß

a) die Gleichstromleitfähigkeit einer einen Ekeltronendonorstoff einarbeitenden Zusammensetzung allein größer als jene des undotierten Poly-(phenylens) ist und

b) die Gleichstromleitfähigkeit einer einen Elektronenakzeptorstoff einarbeitenden Zusammensetzung allein oder im Gemisch mit einem Elektronendonorstoff größer als 1 $Ohm^{-1}$ $cm^{-1}$ ist, wobei die Leitfähigkeit bei Raumtemperatur nach der Vier-Meßfühlermethode gemessen wird.

2. Zusammensetzung nach Anspruch 1, worin der Dotierstoff wenigstens einer aus der Gruppe Lithium, Natrium, Kalium, Rubidium, Caesium, Natriumnaphthalin, Kaliumnaphthalin, Natriumbiphenyl, Kaliumbiphenyl und $HClO_4$, $SO_3$, $N_2O_5$, $Sb_2S_5$, $SbCl_5$, $BCl_3$, $CrO_2Cl_2$, $CrO_2F_2$, $SbF_3Cl_2$, $AsF_5$, $XeF_4$, $XeOF_4$, $SbF_5$, $PF_5$, $BF_5$, $BCl_5$, $SbBr_3$, $CuCl_2$, $NiCl_2$, $MoCl_5$ und $FSO_2OOSO_2F$ ist.

3. Zusammensetzung nach Anspruch 1, worin das Mittel ein Elektronendonor ist, das unter den Metallen der Gruppe IA und den Metallarenen der Gruppe IA ausgewählt ist.

4. Zusammensetzung nach Anspruch 1, worin das Mittel ein Elektronenakzeptor ist, der ein Halogenid der Gruppe V ist.

5. Zusammensetzung nach einem der vorausgehenden Ansprüche, worin der Dotierstoff in einer Menge von $10^{-5}$ bis 0,5 Mol je Mol Monomereinheit des Poly-(phenylens) ist.

6. Zusammensetzung nach einem der vorausgehenden Ansprüche, worin das Poly-(phenylen) im wesentlichen aus Monomereinheiten besteht, die para-Phenylenbindungen enthalten.

7. Geformter Gegenstand, der eine Zusammensetzung nach einem der Ansprüche 1 bis 6 umfaßt.

8. Geformter Gegenstand nach Anspruch 7, der ein elektrischer Leiter, ein Halbleiter, eine n-p-Verbindung, ein Infrarotstrahlungsabsorber oder eine antistatische Einrichtung ist.

## Revendications

1. Composition comprenant un poly(phénylène) solide, se composant essentiellement d'unités monomères ayant des liaisons para-, méta- ou ortho-phénylène, ou leurs mélanges, dans lequel on incorpore au moins un agent de dopage, caractérisé en ce que l'agent de dopage est un agent de dopage formé de donneur ou d'accepteur d'électrons, ou leur mélange, et en ce que

(a) la conductibilité en courant continu d'une composition incorporant un agent donneur d'électrons seul est supérieure à celle du poly(phénylène) non dopé, et

(b) la conductibilité en courant continu d'une composition incorporant un agent accepteur d'électrons seul ou mélangé avec un agent donneur d'électrons est supérieure à 1 $ohm^{-1}$ $cm^{-1}$; cette conductibilité étant mesurée par le procédé à quatre sondes à la température ambiante.

2. Composition selon la revendication 1, dans laquelle l'agent de dopage est au moins un produit constitué par le lithium, le sodium, le potassium, le rubidium, le césium, le naphtalènesodium, le naphtalènepotassium, le biphénylsodium, le biphénylpotassium, $HClO_4$, $SO_3$, $N_2O_5$, $Sb_2S_5$, $SbCl_5$, $BCl_3$, $CrO_2Cl_2$, $CrO_2F_2$, $SbF_3Cl_2$, $AsF_5$, $XeF_4$, $XeOF_4$, $SbF_5$, $PF_5$, $BF_5$, $BCl_5$, $SbBr_3$, $CuCl_2$, $NiCl_2$, $MoCl_5$ et $FSO_2OOSO_2F$.

3. Composition selon la revendication 1, dans laquelle l'agent est un donneur d'électrons choisi parmi les métaux du groupe IA et les arènemétaux du groupe IA.

4. Composition selon la revendication 1, dans laquelle l'agent est un accepteur d'électrons qui est un halogénure d'élément du groupe V.

5. Composition selon l'une quelconque des revendications précédentes, dans lequel l'agent de dopage est présent en quantité de $10^{-5}$ à 0,5 mole par mole d'unité monomère dans le poly(phénylène).

6. Composition selon l'une quelconque des revendications précédentes, dans laquelle le poly(phénylène) se compose essentiellement d'unités monomères contenant des liaisons de paraphénylène.

7. Produit industriel ou article conformé comprenant une composition comme revendiquée dans l'une quelconque des revendications 1 à 6.

8. Article conformé selon la revendication 7 qui est un conducteur électrique, un semiconducteur, une jonction n-p, un dispositif d'absorption de rayonnement infrarouge ou un dispositif antistatique.